Europäisches Patentamt

European Patent Office

Office européen des brevets

(19)

(11) **EP 0 660 981 B1**

(12) **FASCICULE DE BREVET EUROPEEN**

(45) Date de publication et mention
de la délivrance du brevet:
**16.10.1996 Bulletin 1996/42**

(21) Numéro de dépôt: **93919421.3**

(22) Date de dépôt: **06.09.1993**

(51) Int Cl.6: **H03H 9/145**

(86) Numéro de dépôt international:
**PCT/FR93/00850**

(87) Numéro de publication internationale:
**WO 94/07307 (31.03.1994 Gazette 1994/08)**

(54) **TRANSDUCTEUR D'ONDES UNIDIRECTIONNEL**

Wandler für unidirektionale Weller

UNIDIRECTIONAL WAVE TRANSDUCER

(84) Etats contractants désignés:
**CH DE FR GB LI SE**

(30) Priorité: **15.09.1992 FR 9210966**

(43) Date de publication de la demande:
**05.07.1995 Bulletin 1995/27**

(73) Titulaire: **THOMSON-CSF**
**75008 Paris (FR)**

(72) Inventeur: **DUFILIE, Pierre**
**F-92402 Courbevoie Cédex (FR)**

(74) Mandataire: **Desperrier, Jean-Louis et al**
**THOMSON-CSF**
**SCPI**
**B.P. 329**
**50, rue Jean-Pierre Timbaud**
**92402 Courbevoie Cédex (FR)**

(56) Documents cités:
**EP-A- 0 184 508          EP-A- 0 424 240**

- **PROC. OF THE 40th ANNUAL FREQUENCY
SYMP- PHILADELPHIA (US) ; T.N. OLIVER et al :
LOW LOSS, HIGHLY STABLE SAW DEVICES ON
QUARTZ P.269-274**

## Description

La présente invention se rapporte aux transducteurs d'ondes de surface unidirectionnels qui permettent d'émettre à la surface d'un substrat une onde de surface de telle manière que l'essentiel du signal sorte par une extrémité de ce transducteur et que le signal éventuel sortant par l'autre extrémité du transducteur soit d'un niveau très bas par rapport au signal principal.

On connait divers procédés pour réaliser de tels transducteurs, en utilisant par exemple des électrodes flottantes gravées avec une précision supérieure à $\lambda/8$, $\lambda$ étant la longueur d'onde à la fréquence centrale de la bande de fréquence dans laquelle est utilisée le transducteur, ou des couches métalliques ou diélectriques superposées aux métallisations des électrodes. Ces procédés sont délicats à mettre en oeuvre et coûteux.

Pour pallier ces inconvénients, la demanderesse a proposé dans une demande de brevet français n° 89 13747 déposée le 20 octobre 1989 et publiée le 26 avril 1991 sous le 2 653 632 (= EP-A-0 424 240) de réaliser une succession alternée de cellules émettrices et réflectrices dans lesquelles les cellules émettrices comprennent des doigts de largeur sensiblement égale à $\lambda/6$ espacés d'un pas égal à $\lambda/3$ et les cellules réflectrices des doigts de largeur sensiblement égale à $\lambda/4$ espacés d'un pas $\lambda/2$.

Si le progrès apporté par une telle structure est certain, la précision sur la gravure pour obtenir un tel pas de $\lambda/6$ est encore importante et donc délicate à obtenir.

Pour pallier cet inconvénient l'invention propose un transducteur selon la revendication 1.

D'autres particularités et avantages de l'invention apparaîtront clairement dans la description suivante présentée à titre d'exemple non limitatif au regard des figures annexées qui représentent :

- la figure 1, une vue de dessus de la structure de principe connue d'un transducteur unidirectionnel ;
- la figure 2, une vue de dessus d'une cellule émettrice selon l'invention ;
- la figure 3, une vue de dessus d'une cellule réflectrice utilisée dans l'invention ;
- la figure 4, une vue en coupe d'une partie d'un transducteur selon l'invention ;
- la figure 5, une vue semblable à celle de la figure 4, mais permettant de préciser certaines explications ;
- la figure 6, une vue en coupe d'une partie d'un transducteur selon une variante de l'invention ; et
- la figure 7, une vue de dessus partielle d'une autre variante d'un transducteur selon l'invention.

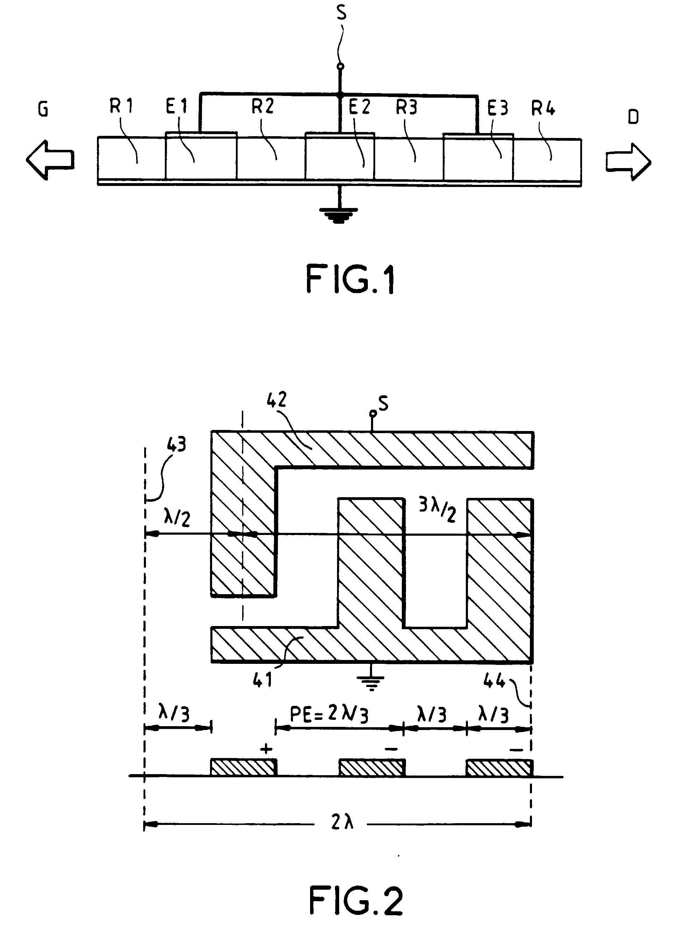

On a représenté sur la figure 1 un exemple montrant la structure générale des électrodes d'un transducteur à réflexion acoustique distribuée, telles qu'elles sont placées sur la surface d'un substrat piézoélectrique qui n'est pas représenté sur la figure.

Ces électrodes sont représentées par des rectangles à l'intérieur desquels on a disposé des moyens d'excitation non représentés, qui se présentent généralement sous la forme de peignes interdigités. Ces peignes sont reliés l'un à la masse et l'autre à une connexion électrique S. Lorsqu'un signal électrique est appliqué en S, une onde acoustique est générée à chacun des accès acoustiques gauches (G) et droit (D), constitués par les extrémités du transducteur. Cet ensemble est d'ailleurs reversible et les ondes acoustiques se propageant sur la surface du substrat peuvent arriver par ces accès pour exciter le transducteur afin qu'il délivre un signal électrique sur la connexion S.

Les électrodes sont groupées sous forme de cellules émettrices $E_1$ à $E_3$ et réflectrices $R_1$ à $R_4$ alignées de manière alternée sur l'axe de propagation des ondes acoustiques. Seules les cellules émettrices qui sont reliées à la connexion électrique S excitent les ondes acoustiques à la surface du substrat, alors que les cellules réflectrices modifient les caractéristiques de propagation acoustique le long de cet axe.

L'invention vise, comme dans la demande de brevet français précitée, à obtenir, à partir de la structure des cellules émettrices et des cellules réflectrices, ainsi que de leur répartition respective, un transfert électroacoustique sensiblement nul entre l'entrée électrique S et l'un des deux accès acoustiques G ou D. Ceci permet d'obtenir un transducteur unidirectionnel uniphasé.

On a représenté sur la figure 2 deux vues d'une cellule émettrice E une vue de dessus située en haut de la figure et une autre vue en coupe située en bas de la figure en correspondance avec la vue d'en haut. Les deux électrodes sont en forme de peignes interdigités. L'électrode 41 reliée à la masse comprend deux doigts et l'électrode 42 reliée à la borne S n'en comprend qu'un. Ces doigts sont répartis avec un pas $P_E = 2\lambda/3$, $\lambda$ étant la longueur d'onde à la fréquence centrale de fonctionnement du dispositif. La largeur nominale des doigts est $\lambda/3$, cette valeur n'étant cependant pas impérative. La succession des doigts est telle que l'on a, en allant de la gauche vers la droite, le doigt unique de l'électrode 42 puis les deux doigts de l'électrode 41. Pour bien délimiter la cellule émettrice par rapport à sa position dans la figure 1, on définira des frontières conventionnelles gauche 43 et droite 44. La frontière gauche 43 sera située à $\lambda/2$ à la gauche du centre du doigt unique de l'électrode 42, et la frontière droite 44 à $3\lambda/2$ à la droite dudit centre. La longueur totale de la cellule entre ses frontières gauche et droite est donc égale à $2\lambda$.

Compte tenu du mode de connexion à la source de signal électrique qui permet d'exciter la cellule, l'électrode 41, qui est reliée à la masse, est une électrode froide et l'électrode 42 une électrode chaude, au sens radioélectrique de ce terme. Ceci est symbolisé sur la figure par les signes - et +. On peut aussi dire que les électrodes + sont "actives" et les électrodes - "inactives". Dans ces conditions le centre d'émission des ondes acoustiques se trouve au centre du doigt unique de l'électrode 42. Compte tenu de la définion des frontières gauche et droite, les ondes acoustiques émises par le doigt unique de l'électrode 42 présentent une différence de phase de 360° à ces deux frontières, et sont donc "en phase".

La cellule représentée sur cette figure 2 est la cellule la plus simple que l'on puisse réaliser selon l'invention. Elle ne représente donc qu'un exemple très particulier et non limitatif d'une cellule émettrice et on peut, en particulier pour augmenter l'efficacité d'émission des ondes acoustiques, l'agrandir en la reproduisant à l'identique par translation $2\lambda$. Les cellules ainsi obtenues par duplication de N fois auront N doigts sur l'électrode 42 et 2N doigts sur l'électrode 41. Ces doigts se succèderont selon la séquence définie par la figure 2. Toutes ces cellules auront la même caractéristique essentielle que la cellule élémentaire de la figure 2, c'est-à-dire que l'onde acoustique sera en phase sur les deux frontières gauche et droite de la cellule. On pourrait d'ailleurs envisager à l'intérieur d'une telle cellule multiple de supprimer un certain nombre des doigts de l'électrode 42, en les reliant par exemple à l'électrode 41, pour pondérer de manière connue le signal émis afin de réaliser par exemple des fonctions de filtrage particulières.

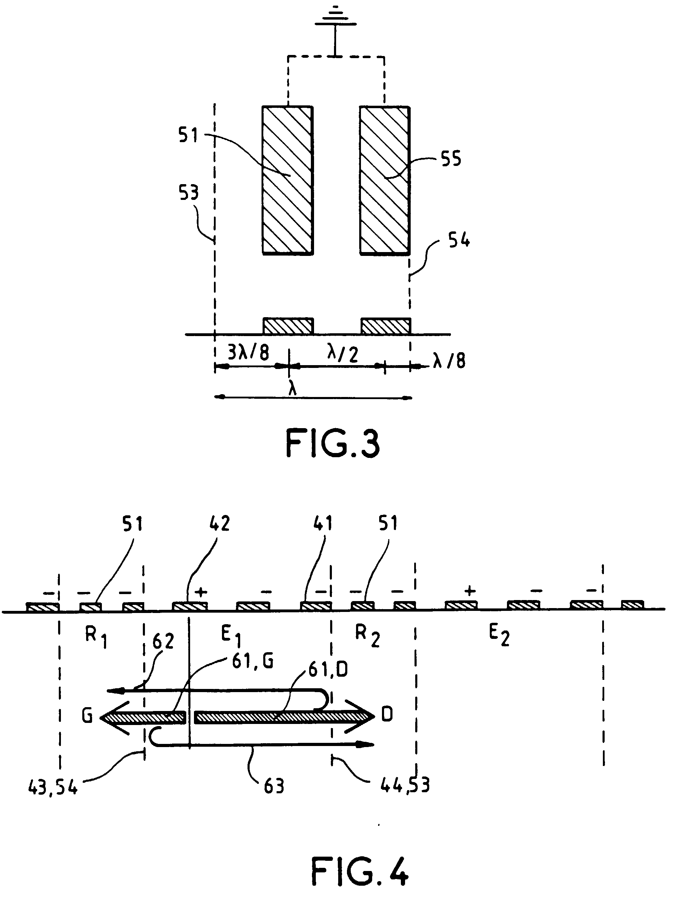

On a représenté sur la figure 3, avec les mêmes conventions que sur la figure 2, une cellule réflectrice comportant deux électrodes en forme de doigts 51 et 55. Ces électrodes sont espacées avec un pas $P_R = \lambda/2$, Leur largeur nominale est de $\lambda/4$. Cette largeur n'est pas impérative. Elles peuvent être soit isolées soit réunies entre elles et à la masse, c'est-à-dire dans ce dernier cas en court-circuit. On définit, comme pour la cellule émettrice, une frontière gauche 53, située à $3\lambda/8$ sur la gauche du centre de l'électrode 51, et une frontière droite 54 située à $\lambda/8$ sur la droite du centre de l'électrode 55. Chacune de ces électrodes se comporte comme un réflecteur élémentaire et il est connu que le coefficient de réflexion de chacun de ces réflecteurs est imaginaire pur, si l'on prend comme référence de phase pour les ondes incidentes et réfléchies l'axe de symétrie de ce réflecteur. Ceci revient à dire que la réflexion se fait avec un changement de phase de + ou - 90°. La détermination entre + ou - dépend de manière connue des propriétés physiques des matériaux et du substrat, en relation avec le fait que les doigts sont isolés ou réunis en court-circuit. Dans le cas le plus général, on a le signe + quand les doigts sont en court-circuit, et le signal - lorsque les doigts sont isolés. Dans la suite de cette description, on considérera le signe +, mais l'invention est aussi valable dans le cas où l'on a le signe -.

Dans ces conditions, en prenant comme origine de référence la frontière gauche 53, la différence de phase sur cette frontière gauche entre l'onde incidente et l'onde réfléchie sur le premier réflecteur 51 est égale à 360°, c'est-à-dire 0°, puisqu'on a un changement de phase de 90° dû à la réflexion et un changement de 270° dû au trajet aller et retour sur une longueur égale à $3\lambda/8$ entre la frontière gauche et le centre du réflecteur. La distance entre les réflecteurs étant égale à $\lambda/2$, le même calcul s'applique pour l'électrode réflectrice 55. L'onde réfléchie sur celle-ci se retrouvera en phase avec l'onde réfléchie sur l'électrode 51 et donc en phase sur la frontière gauche 53 avec l'onde incidente. Compte tenu de ce que le coefficient de réflexion d'une seule électrode est faible, et que donc une grande partie de l'onde incidente provenant de la gauche continue à se propager vers la droite après avoir traversé l'emplacement d'une électrode, le coefficient de réflexion de deux électrodes comme dans la cellule réflectrice simple représentée sur la figure sera égal à 2 fois celui d'une électrode isolée. De même en prenant une cellule réflectrice plus étendue comportant par exemple m électrode réfléchissante, le coefficient de réflexion total de cette cellule sera environ m fois celui d'une électrode unique.

Lorsque les ondes acoustiques arrivent par la droite, elles se réfléchissent elles aussi sur les réflecteurs et, en prenant pour origine des phases la frontière droite 54, la longueur du trajet aller et retour sur la première électrode 55 est égale $\lambda/4$ puisque le centre de réflexion, milieu de cette électrode, est situé à $\lambda/8$ de la frontière droite 54. En tenant compte alors du changement de phase de 90° dû à la réflexion, la différence de phase entre l'onde incidente et l'onde réfléchie au niveau de la frontière droite 54 est égale à 180°. Il en est de même, à 360° près, pour la réflexion sur l'électrode 51 de la figure 3, ainsi que toute autre électrode supplémentaire dans le cas où l'on choisirait une cellule réflectrice plus étendue. La somme des ondes réfléchies sur chacune de ces électrodes donne l'onde totale réfléchie de la même manière que vu plus haut.

En résumé, en prenant pour référence de phase la frontière gauche 53, le coefficient de réflexion pour une onde incidente de la gauche a une phase de 0°. En prenant pour référence de phase la frontière droite 54, le coefficient de réflexion pour une onde incidente de la droite a une phase de 180°.

On a représenté sur la figure 4 une vue en coupe d'une cellule $E_1$ du type décrit ci-dessus, entourée de deux cellules réflectrices $R_1$ et $R_2$ du type décrit ci-dessus. Accessoirement on voit également sur cette figure la coupe d'une cellule $E_2$ et le début de deux autres cellules réflectrices à droite et à gauche de la figure pour bien montrer que $E_1$, $R_1$ et $R_2$ font partie d'un ensemble pour lequel la description du fonctionnement sera identique à celle qui va suivre pour $E_1$, $R_1$ et $R_2$.

Ces cellules sont disposées de telle manière que la frontière gauche de $E_1$ correspond avec la frontière droite de $R_1$ et la frontière droite de $E_1$ avec la frontière gauche de $R_2$. C'est d'ailleurs la raison pour laquelle on a défini ces frontières conventionnelles, pour permettre de décrire plus facilement le positionnement respectif entre les cellules émettrices et les cellules réflectrices. Ainsi donc on a une frontière commune 43-54 à $R_1$ et $E_1$ et une frontière commune 44-53 à $E_1$ et $R_2$.

Les ondes acoustiques 61,G et 61,D qui sont émi-

ses par $E_1$ à partir du centre de l'électrode 42 partent symétriquement des deux côtés de cette électrode vers les frontières de $E_1$.

Pour la cellule $R_2$, l'onde 61,D est incidente de la gauche ; elle est donc partiellement réfléchie avec un déphasage nul à la frontière 44,53 en une onde 62.

Après propagation sur une longueur de $2\lambda$, cette onde 62 arrive à la frontière 43,54. Puisque, comme on l'a vu plus haut, la phase des ondes 61,G, à la frontière 43,54 et 61,D, à la frontière 43,54 sont les mêmes, les ondes 62 et 61.G ont la même phase.

Par contre l'onde 61,G incidente de la droite sur la frontière commune 43,54 s'y réfléchit comme une onde 63 avec un changement de phase de 180°, comme on l'a vu plus haut. De ce fait elle se trouve en opposition de phase sur l'autre frontière commune 44,53 avec l'onde 61,D. Ces ondes 63 et 61,D interfèrent donc destructivement, ce qui entraîne une atténuation de l'onde résiduelle se propageant vers la droite de la figure. Au total on constate que la maille élémentaire formée d'une cellule émettrice $E_1$ encadrée par deux cellules réflectrices $R_1$ et $R_2$ se comporte comme un transducteur qui émet vers la gauche une onde acoustique dont l'amplitude est plus importante que celle de l'onde acoustique émise vers la droite. En répétant cette maille élémentaire un certain nombre de fois, on arrive ainsi à obtenir un transducteur globalement et sensiblement unidirectionnel. En effet, les cellules réflectrices $R_1$ à $R_N$ étant distantes d'un nombre entier de demi-longueurs d'ondes génèrent des ondes réfléchies toutes en phase, ce qui amplifie la propriété décrite plus haut. Il n'est d'ailleurs pas nécessaire que les cellules émettrices et les cellules réflectrices soient toutes identiques, mais il suffit que les conditions de phase aux frontières soient les mêmes que celles définies dans les cellules de bases définies plus haut.

On remarquera aussi que si le coefficient de réflexion propre à chaque réflecteur élémentaire des cellules réflectrices est égal à -90°, le fonctionnement de l'ensemble est inversé, et qu'on obtient un transducteur unidirectionnel de la gauche vers la droite au lieu de la droite vers la gauche.

Il est par ailleurs connu qu'un transducteur du type interdigité émet des fréquences harmoniques les unes des autres qui correspondent aux remises en phase des ondes émises par les doigts actifs. Ainsi pour un transducteur comprenant plusieurs cellules du type de celles représentées sur la figure 2, les fréquences émises correspondent aux longueurs d'onde de $\lambda$ données par la formule :

$$k\lambda = 3P_E.$$

Ceci provient du fait qu'entre deux électrodes + la distance est égale à $3P_E$. On constate donc que l'on émet au moins deux fréquences $F_1$ et $F_2$ dont les longueurs d'onde sont données par :

$$\lambda_1 = 3P_E$$

$$\lambda_2 = \frac{3P_E}{2}$$

Ainsi qu'on l'a décrit plus haut, on choisit selon l'invention pour la longueur d'onde $\lambda_0$ désirée un pas $P_E = 2\lambda_0/3$. Les longueurs d'onde $\lambda_0$ et $\lambda_2$ sont donc identiques. Donc dans ces conditions les cellules émettrices seront non seulement en phase à la fréquence $F_0$ correspondant à $\lambda_0$ mais également à la fréquence $F_0/2$· et également à toutes les fréquences multiples de $F_0/2$. On peut cependant montrer que les fréquences multiples de $3F_0/2$ ne sont pas couplées. La fréquence $F_0/2$ correspond en fait à un sous-harmonique qui est gênant dans la pratique. En effet si le matériau piézoélectrique formant le substrat supportant les peignes est en quartz, ce sous-harmonique $F_0/2$ entraîne la production, par un phénomène physique connu par ailleurs, d'onde de volume à des fréquences proches de $1,6.F_0/2$ et de $1,8.F_0/2$. Comme ces fréquences sont très proches de $F_0$, elles génèrent des raies parasites détériorant la réjection du filtre.

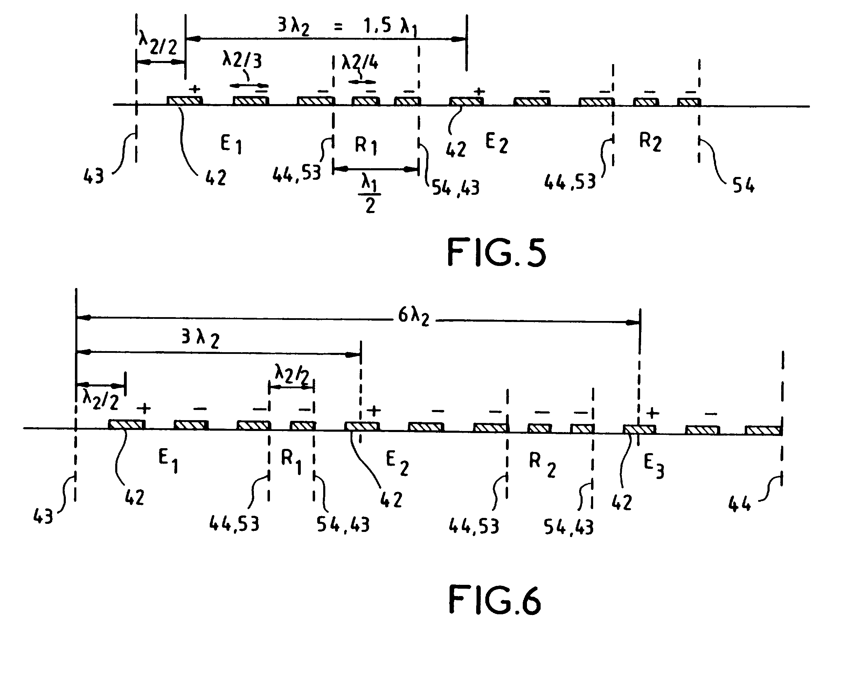

Pour que les fréquences à la longueur d'onde $\lambda 1$, qui risquent donc d'exciter les ondes de volume, ne soient pas émises, il faut qu'il n'y ait pas de remise en phase pour cette fréquence d'une cellule émettrice à la suivante. On a représenté sur la figure 5 deux cellules émettrices $E_1$ et $E_2$, du type décrit plus haut, séparées par deux cellules réflectrices $R_1$ et $R_2$ du même type que décrit plus haut. La fréquence utile à émettre est $\lambda_2$ et la fréquence parasite à ne pas émettre est $\lambda_1$. Pour que cette fréquence parasite soit éliminée, il faut que les centres de phase des doigts émetteurs 42 des deux cellules $E_1$ et $E_2$ soient séparés d'une distance égale à un nombre impair de fois $\lambda_1/2$. Comme on le constate sur la figure cette condition est justement réalisée pour le cas des cellules émettrices et réflectrices correspondant aux figures 2 et 3 utilisées dans le réflecteur distribué de la figure 4 puisque alors cette distance entre les deux centres de phase est égale à $3\lambda_2 = 1,5\lambda_1$. Ceci peut se généraliser en l'exprimant sous la forme d'une condition qui est que la période entre deux cellules d'émission successives soit égale à $2(2m+1)/\lambda_2$ c'est-à-dire à un multiple impair de 2 longueurs d'onde à la fréquence d'utilisation. Dans le cas de la figure, $m = 0$ et le multiple impair est égal à 1.

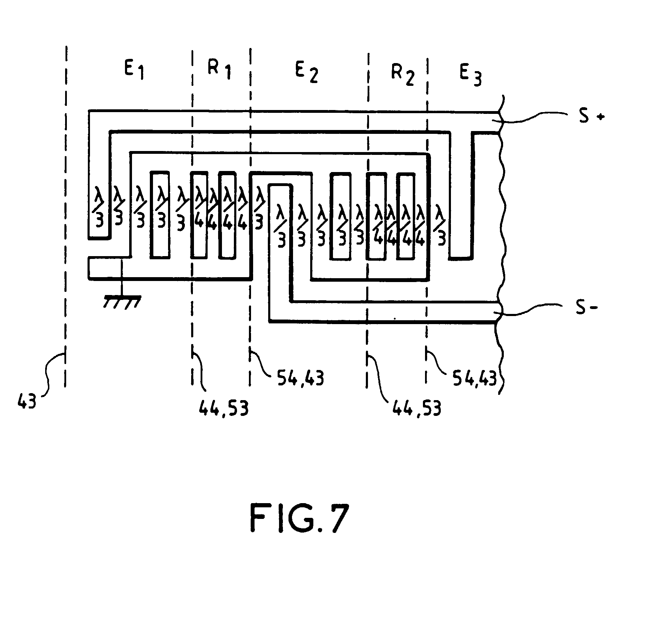

En outre il est aussi possible, comme représenté sur la figure 6, d'utiliser certaines cellules réflectrices ayant un nombre impair de doigts, comme la cellule $R_1$ qui a un doigt unique. Ainsi les ondes émises d'une part par la cellule émettrice $E_1$ et d'autre part par les cellules émettrices $E_2$ et $E_3$ seront en opposition de phase à la frontière gauche 43 de la cellule émettrice $E_1$ pour la fréquence correspondant à la longueur d'onde utile $\lambda_2$. Ceci permet donc d'obtenir aussi bien des composantes positives et négatives en choisissant un tel nombre impair de réflecteurs pour une cellule réflectrice et donc d'obtenir des poids positifs et négatifs lorsqu'on utilise une technique de pondération des cellules émettrices par suppression de sources. Cette technique est connue sous la terminologie anglo-saxonne "withdrawal". On peut enfin utiliser une structure permettant une alimentation différentielle entre une source + et une source -, par rapport à la masse, comme représenté sur la figure 7 qui comporte deux cellules émettrices $E_1$ et $E_3$ reliées à la source + encadrant une cellule émettrice $E_2$ reliée à la source -, et ces trois cellules étant séparées par des cellules réflectrices $R_1$ et $R_2$ reliées éventuellement à la masse, ces cellules étant naturellement mises au potentiel de la masse par symétrie.

Cette configuration permet d'utiliser une structure en méandres dans laquelle les électrodes reliées à la masse s'intercalent entre celles reliées à la source + et celles reliées à la source -. On obtient ainsi une protection accrue vis-à-vis des parasites électrostatiques et pyroélectriques.

Toutes les structures décrites ci-dessus ont l'avantage de pouvoir être réalisées avec un seul niveau de métallisation et une seule étape de photogravure. Par rapport aux réalisations connues jusqu'à présent, où la précision de la photogravure devait atteindre $\lambda/6$, celle-ci est limitée à $\lambda/4$ et $\lambda/3$, ce qui permet pour une même précision de photogravure d'obtenir un dispositif pouvant fonctionner à des fréquences supérieures de 50% à celles généralement utilisées.

## Revendications

1. Transducteur d'ondes de surface unidirectionnel, du type comportant un alignement en successions alternées de cellules émettrices (E) et réflectrices (R) réparties de telle manière que les ondes acoustiques émises par des cellules émettrices et réfléchies par les cellules réflectrices s'additionnent constructivement dans un sens de propagation et destructivement dans l'autre sens de propagation, caractérisé en ce que les cellules émettrices sont constituées de deux électrodes (41, 42) en forme de peignes interdigités présentant un pas ($P_E$) égal à $2\lambda/3$; $\lambda$ étant la longueur d'onde centrale de fonctionnement du transducteur.

2. Transducteur selon la revendication 1, caractérisé en ce que les doigts des électrodes des cellules émettrices (41, 42) présentent une largeur proche de $\lambda/3$,

3. Transducteur selon la revendication 2, caractérisé en ce que les électrodes (41, 42) de chaque cellule émettrice sont formés d'au moins un groupement de trois doigts comprenant un doigt actif (42) suivi de deux doigts inactifs (41).

4. Transducteur selon la revendication 3, caractérisé en ce que les cellules émettrices sont composées d'une succession d'ensembles de trois doigts comportant un doigt actif suivi de deux doigts inactifs.

5. Transducteur selon l'une quelconque des revendications 1 à 4, caractérisé en ce que les cellules réflectrices (R) comprennent des doigts (51, 55) espacés d'un pas égal à $\lambda/2$ et présentent une largeur proche de $\lambda/4$, les cellules d'émission adjacentes étant positionnées de telle manière que le centre du doigt actif le plus proche est situé à $\frac{5\lambda}{8}+k\frac{\lambda}{2}$ des centres des réflecteurs pour un côté et $15\lambda/8+k\lambda/2$ de l'autre.

6. Transducteur selon la revendication 5, caractérisé en ce que les cellules d'émission sont séparées majoritairement par un nombre impair de longueurs d'onde.

7. Transducteur selon la revendication 6, caractérisé en ce qu'au moins l'une des cellules réflectrices ($R_1$) comprend un nombre de doigts impair permettant de réaliser des sources de signes opposés.

8. Tranducteur selon l'une quelconque des revendications 1 à 7, caractérisé en ce que d'une cellule émettrice à la suivante les électrodes actives sont reliées successivement à une source positive (S+) puis à une source négative (S-), ces électrodes actives étant séparées d'un nombre impair de demi-longueurs d'onde, et que les électrodes inactives des cellules émettrices ainsi que les doigts des cellules réflectrices ($R_1$, $R_2$ sont reliés ensemble, et éventuellement à la masse, en adoptant une configuration en méandres qui permet d'isoler au point de vue électrostatistique et pyroélectrique les électrodes reliées à la source positive des électrodes reliées à la source négative.

## Patentansprüche

1. Unidirektionaler Oberflächenwandler des Typs, der abwechselnde Folgen von in einer Richtung angeordneten Sendezellen (E) und reflektierenden Zellen (R) enthält, die in der Weise verteilt sind, daß die von den Sendezellen ausgesendeten Schallwellen, die von den reflektierenden Zellen reflektiert werden, sich in einer Ausbreitungsrichtung konstruktiv und in der anderen Ausbreitungsrichtung destruktiv addieren, dadurch gekennzeichnet, daß die Sendezellen aus zwei Elektroden (41, 42) in Form interdigitaler Kämme gebildet sind, die eine Schrittweite ($P_2$) aufweisen, die gleich 2 $\lambda/3$ ist; wobei $\lambda$ die mittlere Betriebswellenlänge des Wandlers ist.

**2.** Wandler nach Anspruch 1, dadurch gekennzeichnet, daß die Finger der Elektroden der Sendezellen (41, 42) eine Breite von ungefähr λ/3 aufweisen.

**3.** Wandler nach Anspruch 2, dadurch gekennzeichnet, daß die Elektroden (41, 42) jeder Sendezelle aus wenigstens einer Gruppierung von drei Fingern gebildet sind, die einen aktiven Finger (42), gefolgt von zwei inaktiven Fingern (41), enthält.

**4.** Wandler nach Anspruch 3, dadurch gekennzeichnet, daß die Sendezellen aus einer Folge von Gruppen von drei Fingern gebildet sind, die einen aktiven Finger, gefolgt von zwei inaktiven Fingern, enthalten.

**5.** Wandler nach irgendeinem der Ansprüche 1 bis 4, dadurch gekennzeichnet, daß die reflektierenden Zellen (R) Finger (51, 55) enthalten, die um eine Schrittweite beabstandet sind, die gleich λ/2 ist, und die eine Breite aufweisen, die ungefähr λ/4 beträgt, wobei die benachbarten Sendezellen in der Weise angeordnet sind, daß sich die Mitte des nächsten aktiven Fingers von den Mitten der Reflektoren auf einer Seite bei (5 λ/8) + k(λ/2) und auf der anderen Seite bei (15 λ/8 + k(λ/2) befindet.

**6.** Wandler nach Anspruch 5, dadurch gekennzeichnet, daß die Sendezellen mehrheitlich durch eine ungerade Anzahl von Wellenlängen getrennt sind.

**7.** Wandler nach Anspruch 6, dadurch gekennzeichnet, daß wenigstens eine der reflektierenden Zellen ($R_1$) eine ungerade Anzahl von Fingern enthält, die die Verwirklichung von Quellen mit entgegengesetzten Vorzeichen ermöglichen.

**8.** Wandler nach irgendeinem der Ansprüche 1 bis 7, dadurch gekennzeichnet, daß von einer Sendezelle zur folgenden die aktiven Elektroden nacheinander mit einer positiven Quelle (S+), dann mit einer negativen Quelle (S-) verbunden sind, wobei diese aktiven Elektroden um eine ungerade Anzahl von Halbwellenlängen getrennt sind, und daß die inaktiven Elektroden der Sendezellen sowie die Finger der reflektierenden Zellen ($R_1$, $R_2$) miteinander und eventuell mit Masse verbunden sind, indem sie eine Mäanderkonfiguration besitzen, die eine elektrostatische und pyroelektrische Isolation der mit der positiven Quelle verbundenen Elektroden von den mit der negativen Quelle verbundenen Elektroden ermöglicht.

## Claims

**1.** Unidirectional surface wave transducer of the type comprising a line of emitter cells (E) and reflector cells (R) alternating in succession and distributed in such a way that the acoustic waves emitted by emitter cells and reflected by the reflector cells are added together constructively in one direction of propagation and destructively in the opposite direction of propagation, characterized in that the emitter cells consist of two electrodes (41, 42) in the form of interdigitated combs having a spacing ($P_E$) equal to 2λ/3, λ being the central wavelength of operation of the transducer.

**2.** Transducer according to Claim 1, characterized in that the electrode fingers of the emitter cells (41, 42) have a width approaching λ/3.

**3.** Transducer according to Claim 2, characterized in that the electrodes (41, 42) of each emitter cell consist of at least one grouping of three fingers, including an active finger (42) followed by two inactive fingers (41).

**4.** Transducer according to Claim 3, characterized in that the emitter cells are composed of a succession of units of three fingers consisting of one active finger followed by two inactive fingers.

**5.** Transducer according to any of Claims 1 to 4, characterized in that the reflector cells (R) comprise fingers (51, 55) spaced apart by a spacing equal to λ/2 and have a width approaching λ/4, the adjacent emitter cells being positioned in such a way that the centre of the closest active finger is located

$$\frac{5\lambda}{8} + k\frac{\lambda}{2}$$

from the centre of the reflectors on one side, and

$$\frac{15\lambda}{8} + k\frac{\lambda}{2}$$

on the other.

**6.** Transducer according to Claim 5, characterized in that the majority of the emitter cells are separated by an odd number of wavelengths.

**7.** Transducer according to Claim 6, characterized in that at least one of the reflector cells ($R_1$) comprises an odd number of fingers making it possible to produce sources having opposite signs.

**8.** Transducer according to any of Claims 1 to 7, characterized in that, from one emitter cell to the next, the active electrodes are connected in succession to a positive source (S+), then to a negative source (S-), these active electrodes being separated by an odd number of half-wavelengths, and in that the inactive electrodes of the emitter cells, as well as the fingers of the reflector cells ($R_1$, $R_2$) are connected together and possibly grounded, by using an intricately-patterned configuration making it possible to isolate electrostatically and pyroelectrically the electrodes connected to the positive source from the electrodes connected to the negative source.

EP 0 660 981 B1

FIG.1

FIG.2

8

FIG.3

FIG.4

EP 0 660 981 B1

FIG.5

FIG.6

FIG.7